Europäisches Patentamt

European Patent Office

Office européen des brevets

(11) Veröffentlichungsnummer: **0 466 103 A1**

## (12) EUROPÄISCHE PATENTANMELDUNG

(21) Anmeldenummer: **91111415.5**

(22) Anmeldetag: **09.07.91**

(51) Int. Cl.5: **H01L 21/28**, H01L 29/60

(30) Priorität: **11.07.90 DE 4022030**

(43) Veröffentlichungstag der Anmeldung:
**15.01.92 Patentblatt 92/03**

(84) Benannte Vertragsstaaten:
**DE FR GB**

(71) Anmelder: **SIEMENS AKTIENGESELLSCHAFT**
**Wittelsbacherplatz 2**
**W-8000 München 2(DE)**

(72) Erfinder: **Willer, Josef, Dr.**
**Fr.-Fröbel-Strasse 62**
**W-8012 Riemerling(DE)**
Erfinder: **Ristow, Dietrich, Dr.**
**Pappelstrasse 35**
**W-8014 Neubiberg(DE)**

(54) **Verfahren zur Herstellung einer Metallisierung beim Aufdampfen mit einer schrägen Einfallsrichtung auf Halbleitermaterial.**

(57) Verfahren zur Herstellung einer Metallisierung mit kleiner Kontaktfläche und großem Querschnitt auf Halbleitermaterial (1), insbesondere als Gate-Metallisierung eines FETs, unter Verwendung einer Maske (2), die mindestens einen als Kontaktfläche vorgesehenen Bereich freiläßt, bei dem in einer schrägen Einfallsrichtung anisotrop eine Schicht aus Dielektrikum (3) aufgebracht und dann in einer anderen Einfallsrichtung die Metallisierung (4) auf die von dem Dielektrikum (3) nicht bedeckte Kontaktfläche mit einem den großen Querschnitt bewirkenden Anteil auf dem Dielektrikum (3) aufgebracht wird.

# FIG 1

# FIG 2

# FIG 3

# FIG 4

Die vorliegende Erfindung betrifft ein Verfahren zur Herstellung einer Metallisierung mit kleiner Kontaktfläche auf Halbleitermaterial entsprechend dem Oberbegriff des Anspruches 1.

Die vorliegende Erfindung betrifft insbesondere die Gestaltung des Gate-Bereiches von Metall-Halbleiter-Feldeffekttransistoren (FET), insbesondere von MESFET und HEMT auf GaAs-Substraten. Bei Feldeffekttransistoren für hohe Leistungen kommt es darauf an, die Länge des Gates möglichst gering zu halten, was durch eine kleine Kontaktfläche zwischen dem Metall der Gate-Metallisierung und dem Halbleitermaterial erreicht wird. Eine gute Tauglichkeit für hohe Frequenzen wird nur erreicht, wenn der Querschnitt der Metallisierung ausreichend groß ist, um den Zuleitungswiderstand gering zu halten.

Eine Möglichkeit, eine Metallisierung mit kleiner Kontaktfläche herzustellen, besteht darin, das Metall mit schräger Einfallsrichtung aufzudampfen. Wenn der für Source und Drain vorgesehene Bereich von einer Maske abgedeckt ist, erhält man mit diesem Verfahren einen asymmetrisch zu Source und Drain angeordneten Gate-Kontakt. Durch den schrägen Einfallswinkel erreicht man, daß das Metall nur in einer schrägen Projektion der Öffnung der Maske abgeschieden wird. Es wird daher nur ein kleiner Bereich des von der Maske freigelassenen Bereiches der Halbleiteroberfläche mit dem Metall bedampft. So erhält man einen Metall-Halbleiter-Kontakt mit sehr kleiner Kontaktfläche. Diese Fläche bleibt aber nur klein, solange die aufgedampfte Menge an Metall gering ist. Ein großer Querschnitt der Metallisierung läßt sich auf diese Weise nicht herstellen. Die Hochfrequenztauglichkeit eines mit dieser Technik hergestellten Transistors ist daher begrenzt. (Vgl. J. F. Allison et al., Solid State Technology June 1986, 169-175).

Aufgabe der vorliegenden Erfindung ist es, ein Verfahren zur Herstellung einer Metallisierung auf Halbleitermaterial mit kleiner Kontaktfläche und großer Querschnittsfläche anzugeben.

Diese Aufgabe wird mit dem Verfahren mit den Merkmalen des Anspruchs 1 gelöst. Weitere Ausgestaltungen ergeben sich aus den Unteransprüchen.

Bei den erfindungsgemäßen Verfahren wird die Metallisierung mit einer schrägen Einfallsrichtung aufgedampft. Um ein Abscheiden einer größeren Metallmenge zu ermöglichen, wird vorher aus einer ebenfalls schrägen, aber entgegengesetzt geneigten Einfallsrichtung eine Schicht aus Dielektrikum aufgebracht, die den nicht mit dem Metallkontakt zu versehenden Bereich der Halbleiteroberfläche abdeckt und gleichzeitig isoliert. Daher kann soviel Metall für die Metallisierung abgeschieden werden, daß sich eine diese Dielektrikumschicht bedeckende Metallisierung mit großem Querschnitt ergibt.

Es folgt eine Beschreibung des erfindungsgemäßen Verfahrens anhand der Fig. 1 bis 7.

Fig. 1 bis 4    zeigen einen nach dem erfindungsgemäßen Verfahren hergestellten FET im Querschnitt jeweils nach vier verschiedenen Prozeßschritten.

Fig. 5 bis 7    zeigen einen erfindungsgemäß hergestellten FET im Querschnitt jeweils nach drei verschiedenen Schritten einer Alternative des erfindungsgemäßen Herstellungsverfahrens.

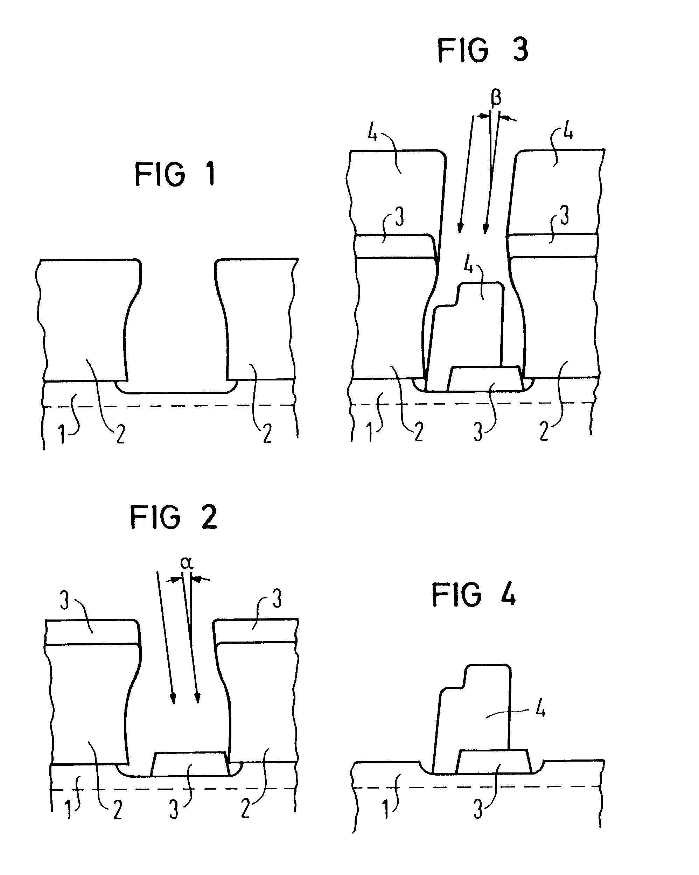

Fig. 1 zeigt das Halbleitermaterial 1 mit einer darauf aufgebrachten Maske 2. Durch die gestrichelte Linie in dem Halbleitermaterial 1 ist eine oberste Schicht oder Schichtfolge aus Halbleitermaterial oder ein oberster Schichtanteil eines Substrates 1 hervorgehoben. In dieser Schicht wird der Kanalbereich des Gate ausgebildet. In diesem Ausführungsbeispiel dient die Maske 2 auch dazu, in einem ersten Schritt des Verfahrens diese oberste Schicht des Halbleitermateriales 1 in der dargestellten Weise soweit auszuätzen, wie erforderlich ist, um für den Kanalbereich eine bestimmte Durchbruchspannung zwischen Gate und Drain, insbesondere für Leistungstransistoren, festzulegen. Die physikalischen Eigenschaften ergeben sich dabei durch die Tiefe dieser Ausätzung und das Dotierungsprofil des oberen Schichtanteiles. Dieser Ätzschritt kann auch entfallen, wenn der Kanalbereich durch die Dotierung bzw. durch epitaktisch aufgewachsene Schichten entsprechender Dicke in der erforderlichen Weise ausgebildet ist. Die Maske 2 wird dann auf eine ebene Halbleiteroberfläche aufgebracht. Die Maske ist z. B. aus Photolack, der zur Verbesserung der konventionellen Abhebetechnik durch Hilfsschichten auf oder unter dem Photolack ergänzt sein kann.

Fig. 2 zeigt den erfindungswesentlichen Verfahrensschritt. In einer Richtung, die um einen Winkel $\alpha$ aus der Senkrechten auf die Oberfläche des Halbleitermateriales gedreht ist, wird ein Dielektrikum 3 anisotrop aufgebracht. Ein Anteil dieses Dielektrikums wird auf der Maske 2 abgeschieden, ein anderer Anteil bildet eine Schicht auf dem Halbleitermaterial. Diese durch das Dielektrikum 3 gebildete Schicht füllt nicht den gesamten von der Maske 2 freigelassenen Bereich auf, sondern läßt einen für die Kontaktierung mit der Gate-Metallisierung vorgesehenen Bereich frei. Das Dielektrikum kann z. B. $SiO_2$, das mit einer Elektronenkanone aufgedampft wird, sein. Der Winkel $\alpha$, den die Einfallsrichtung zur Senkrechten bildet, wird durch das Profil der Maske 2, deren Dicke und gegebenenfalls die Tiefe der entsprechend Fig. 1 erfolgten Ätzung festgelegt. Die Schicht, die durch das Dielektrikum 3 auf dem Halbleitermaterial gebildet wird, sollte mit ihrer nicht an den für die Kontaktierung vorgesehenen Bereich angrenzenden Berandung möglichst bündig an den Fuß der Maske 2 anschließen. Damit wird die Grenze zwischen der Maske 2 und dem Dielektrikum 3 für den nachfolgenden Verfahrensschritt des Aufdampfens der Metallisierung abgedichtet.

Das Aufdampfen der Metallisierung 4 ist in Fig. 3 dargestellt. Das Aufdampfen der Metallisierung erfolgt anisotrop in einer Einfallsrichtung, die auf den von dem Dielektrikum 3 freigelassenen Bereich der Halbleiteroberfläche ausgerichtet ist. Diese Einfallsrichtung verläuft vorteilhaft ebenfalls schräg. Der Winkel $\beta$, den die Einfallsrichtung für das Aufdampfen der Metallisierung mit der Senkrechten auf die Halbleiteroberfläche bildet, liegt dem Winkel der Einfallsrichtung für das Aufbringen des Dielektrikums 3 gegenüber. Auf diese Weise wird erreicht, daß das Dielektrikum 3 im wesentlichen auf der einen Seite der von der Maske freigelassenen Öffnung abgeschieden wird und die Metallisierung im wesentlichen auf der anderen Seite dieses von der Maske 2 freigelassenen Bereiches aufgedampft wird. Es wird aber so viel Metall abgeschieden, daß nicht nur der für die Kontaktierung vorgesehene Bereich mit Metall versehen wird, sondern ein erheblicher Anteil des Metalles auch auf der durch das Dielektrikum 3 gebildeten Schicht abgeschieden wird. Auf diese Weise erhält man eine Metallisierung 4 mit einem gegenüber herkömmlichen Verfahren erheblich vergrößerten Querschnitt und damit einem niedrigen Zuleitungswiderstand.

Die Maske 2 wird anschließend mit den darauf befindlichen Anteilen des Dielektrikums 3 und dem Metall 4 durch Lacklösungsmittel entfernt. Diese Abhebetechnik erfolgt in konventioneller Weise, so daß der in Fig. 4 gezeigte Aufbau zurückbleibt. Damit erhält man ein für Hochfrequenzanwendungen geeignetes Gate mit kurzer Gate-Länge und großem Gate-Querschnitt. Dieses Gate besitzt eine Kontaktfläche zum Halbleitermaterial, die asymmetrisch in dem ausgeätzten Teil der Halbleiteroberfläche angeordnet ist. Dadurch wird der Source-Widerstand klein, was sowohl für Kleinsignal- als auch für Großsignalanwendungen vorteilhaft ist.

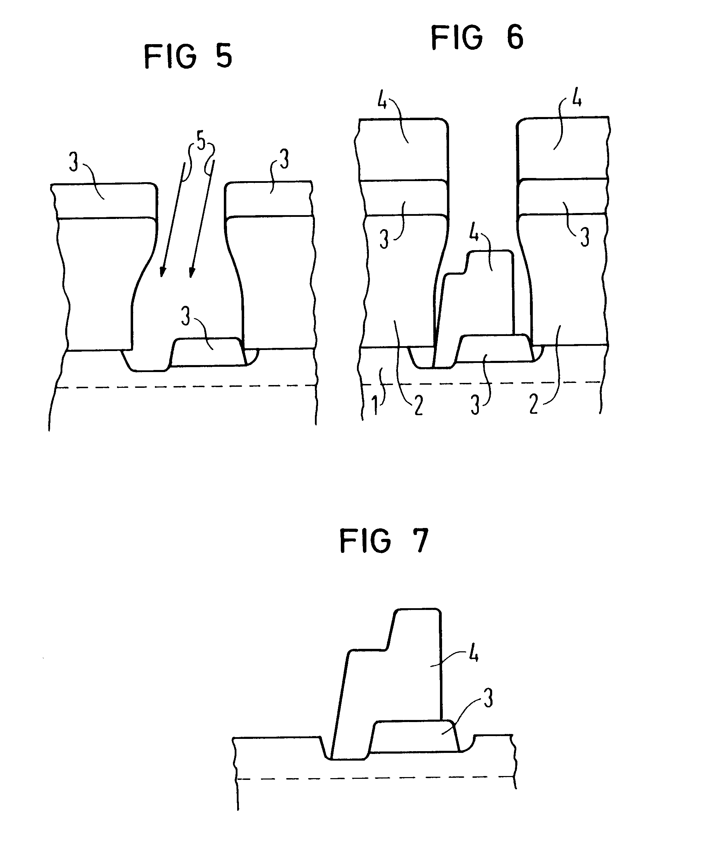

Fig. 5 zeigt einen weiteren Verfahrensschritt, der zwischen dem Aufbringen des Dielektrikums und dem Aufdampfen der Metallisierung eingeschaltet werden kann. In diesem Verfahrensschritt wird die Oberfläche des Halbleitermateriales 1 in dem nicht von dem Dielektrikum 3 bedeckten Bereich weiter ausgeätzt. Damit kann eine weitere Verringerung des Source-Widerstandes erzielt werden, da Source- und Gate-Bereich unabhängig voneinander optimiert werden können. Das Gate ist dann tiefer in dem Kanalbereich versenkt. In Fig. 6 ist für diese Alternative des Herstellungsverfahrens der Querschnitt beim Aufdampfen der Metallisierung dargestellt. Die fertige Metallisierung sieht im Querschnitt dann entsprechend Fig. 7 aus.

Bei einer Dicke der Lackmaske 2 von 1 μm können die Winkel $\alpha$, $\beta$ jeweils etwa 7° in entgegengesetzte Richtungen gewählt werden.

Das erfindungsgemäße Herstellungsverfahren bietet eine Reihe von Vorteilen gegenüber dem Stand der Technik. Es kann sowohl bei ionenimplantierten und ausgeheilten Schichten aus Halbleitermaterial als auch bei epitaktisch aufgewachsenen Schichten angewandt werden. Ein zusätzliches, auf die Kontaktfläche beschränktes Abätzen des Halbleitermateriales ist nur bei dem erfindungsgemäßen Verfahren möglich. Das erfindungsgemäße Verfahren ist besonders für FETs geeignet, läßt sich aber für beliebige Metallisierungen auf Halbleitermaterial anwenden, bei denen eine kleine Kontaktfläche bei gleichzeitig großer Querschnittsfläche der Metallisierung gefordert wird.

**Patentansprüche**

1. Verfahren zur Herstellung einer Metallisierung (4) mit kleiner Kontaktfläche auf einer Oberfläche eines Halbleitermateriales (1) unter Verwendung einer Maske (2), die mindestens einen als Kontaktfläche vorgesehenen Bereich freiläßt, bei dem diese Metallisierung (4) in einer aus der Senkrechten zu dieser Oberfläche um einen Winkel ($\beta$) gedrehten ersten Richtung aufgebracht wird,
**dadurch gekennzeichnet,**
daß vor dem Aufbringen der Metallisierung (4) anisotrop in einer aus der Senkrechten zu der Oberfläche entgegen dem Drehsinn der ersten Richtung um einen Winkel ($\alpha$) gedrehten zweiten Richtung eine Schicht aus einem Dielektrikum (3) aufgebracht wird,
daß diese Schicht aus dem Dielektrikum (3) den als Kontaktfläche vorgesehenen Bereich freiläßt und
daß nach dem Aufbringen der Metallisierung (4) die Maske (2) mit darauf befindlichen Anteilen des Dielektrikums (3) entfernt wird.

2. Verfahren nach Anspruch 1,
**dadurch gekennzeichnet,**
daß nach dem Aufbringen der Schicht aus dem Dielektrikum (3) und vor dem Aufbringen der Metallisierung (4) das Halbleitermaterial (1) in dem als Kontaktfläche vorgesehenen Bereich abgeätzt wird.

3. Verfahren nach einem der Ansprüche 1 oder 2, angewendet bei der Herstellung eines FET,
**dadurch gekennzeichnet,**
daß die Metallisierung (4) als Gate-Metallisierung aufgebracht wird.

4. Verfahren nach Anspruch 3,
   **dadurch gekennzeichnet,**
   daß vor dem Aufbringen der Schicht aus dem Dielektrikum (3) das Halbleitermaterial (1) unter Verwendung der Maske (2) abgeätzt wird und dadurch ein Kanalbereich für den FET hergestellt wird.

FIG 3

FIG 1

FIG 2

FIG 4

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,Y | IEEE ELECTRON DEVICE LETTERS. vol. EDL-4, no. 4, April 1983, NEW YORK US Seiten 99 - 101; Y. IMAI et al.: "A sub-half-micron gate-length GaAs MESFET with new gate structure" * Seite 99, rechte Spalte - Seite 100, linke Spalte; Figuren 1a-1d *<br><br>– – – | 1,3,2,4 | H 01 L 21/28 H 01 L 29/60 |
| Y,A | MICROELECTRONIC ENGINEERING. vol. 5, no. 1-4, Dezember 1986, AMSTERDAM NL Seiten 239 - 246; K.H. MUELLER et al.: "Synchrotron lithography for sub-half-micron T-gates in GaAs FET" * Seite 243, Absatz 3; Figur 5 *<br><br>– – – | 2,1,3,4 | |
| Y,A | US-A-4 551 905   (PANE-CHANE CHAO ET AL.) * Spalte 7, Zeile 64 - Spalte 9, Zeile 47; Figuren 1, 6-8 *<br><br>– – – | 4,1,3 | |
| X | DE-A-3 913 540   (LICENTIA PATENT-VERWALTUNGS-GMBH) * Spalte 1, Zeile 43 - Spalte 2, Zeile 59; Ansprüche 1, 2, 5-7; Figuren 9-11 *<br><br>– – – | 1-3 | |
| A,A | JOURNAL OF VACUUM SCIENCE AND TECHNOLOGY: PART B. vol. 3, no. 4, Juli 1985, NEW YORK US Seiten 956 - 958; L.B. HOLDEMAN et al.: "An approach to fabricating sub-half-micrometer-length gates for GaAs metal-semiconductor field-effect transistors" * Seiten 956 - 957, linke Spalte; Figuren 1-3 *<br><br>– – – | 1,3,4 | **RECHERCHIERTE SACHGEBIETE (Int. Cl.5)**<br><br>H 01 L |
| A | JOURNAL OF THE ELECTROCHEMICAL SOCIETY. vol. 133, no. 10, Oktober 1986, MANCHESTER, NEW HAMP Seiten 409C - 416C; C.E. WEITZEL et al.: "A review of GaAs MESFET Gate electrode fabrication technologies" * Seiten 413 - 414C, linke Spalte; Figuren 16, 17 *<br><br>– – – – – | 1,3,4 | |

Der vorliegende Recherchenbericht wurde für alle Patentansprüche erstellt

| Recherchenort | Abschlußdatum der Recherche | Prüfer |
|---|---|---|
| Berlin | 29 August 91 | KLOPFENSTEIN P R |